# FASCICULE DE BREVET EUROPEEN

(11) **EP 1 070 762 B1**
(45) Date de publication et mention de la délivrance du brevet: **29.09.2004**
(21) Numéro de dépôt: 00402052.5
(22) Date de dépôt: 19.07.2000
(51) Int. Cl.: C22C 21/00, G02B 5/08, G02B 1/10, C23C 14/20

(54) **Revêtements réflecteurs comprenant un alliage aluminium-titane à réflectivité spéculaire élevée, et miroirs et pièces comportant ce revêtement**
Reflektionsbeschichtungen aus einer Aluminium-Titan-Legierung mit hoher Spekularreflektion, sowie Spiegel oder Bauteile mit dieser Beschichtung
Reflective coatings comprising an aluminium-titanium alloy having high specular reflectivity, and mirrors or components with this coating

(30) Priorité: 19.07.1999 FR 9909335
(43) Date de publication de la demande: 24.01.2001
(73) Titulaire: CENTRE STEPHANOIS DE RECHERCHES MECANIQUES HYDROMECANIQUE ET FROTTEMENT, F-42160 Andrezieux-Boutheon (FR)
(72) Inventeur: Martin, Michel, 69780 Mions (FR); Faverjon, Frédéric, 42240 Unieux (FR); Moreau, Janick, 77210 Samoreau (FR); Poirson, Jean-Marc, 42130 Saint-Etienne le Mollard (FR); Terrat, Jean-Paul, 42000 Saint-Etienne (FR)
(74) Mandataire: Santarelli

(56) Documents cités:
- US-A- 4 992 087
- DATABASE WPI Section Ch, Week 198631 Derwent Publications Ltd., London, GB; Class L01, AN 1986-201417 XP002135003 -& JP 61 133902 A (NIPPON JIDOSHA BUHIN SOGO), 21 juin 1986 (1986-06-21)
- PATENT ABSTRACTS OF JAPAN vol. 018, no. 250 (P-1736), 12 mai 1994 (1994-05-12) -& JP 06 028717 A (RICOH CO LTD), 4 février 1994 (1994-02-04)
- T.B.MASSALSKI: "Binary Alloy Phase Diagrams, Vol.1, pages 175-176" 1986 , ASM , OHIO, US XP002135002 * page 175 *
- PATENT ABSTRACTS OF JAPAN vol. 1995, no. 07, 31 août 1995 (1995-08-31) -& JP 07 090566 A (TDK CORP), 4 avril 1995 (1995-04-04)

## Description

La présente invention concerne un revêtement réflecteur en alliage aluminium-titane à réflectivité spéculaire élevée, ainsi que des miroirs et des pièces comportant ce revêtement.

Plus particulièrement, l'invention se rapporte à la conception et la fabrication de miroirs spéciaux. On entend par miroirs spéciaux des miroirs dont les caractéristiques optiques doivent être comprises dans un domaine bien défini et qui doivent être conservées intégralement, même lorsqu'ils sont soumis à des contraintes sévères comme, à titre d'exemple non limitatif, des atmosphères particulièrement corrosives comme les atmosphères humides, avec ou sans condensation, avec présence d'agents chimiques tels que le chlorure de sodium par exemple. Plus particulièrement encore, mais de façon non limitative, l'invention a trait à des miroirs réalisés par dépôt d'une couche métallique sur un support en matière plastique ou en matériau composite, dans ce dernier cas en effet, l'interface entre le revêtement réflecteur et le substrat, habituellement polymérique, est particulièrement sensible à l'environnement et est le siège de dégradations irréversibles.

Pour réaliser des miroirs spéciaux devant résister aux ambiances agressives, on procède souvent en déposant une couche métallique sur un support faisant office de structure adéquate. Cette couche métallique est ensuite protégée contre les agressions mécaniques, chimiques ou autres par un film protecteur transparent. Ce film protecteur peut être, à titre d'exemple non limitatif, un oxyde ou oxynitrure métallique, mais pour des raisons économiques, c'est très souvent un polymère.

Un tel miroir comporte donc deux interfaces, substrat/revêtement réflecteur et revêtement réflecteur/film protecteur qui sont les points faibles du système car elles peuvent être le siège de délaminations entraînant ternissement, cloquage et, dans tous les cas, une dégradation importante du miroir.

Selon l'art antérieur, la réalisation des miroirs spéciaux décrits plus haut fait généralement appel au dépôt d'un métal dit de la mine du platine, c'est-à-dire du groupe VIII de la classification périodique de Mendéléeff et, plus particulièrement le rhodium, le ruthénium ou le palladium. Ces métaux possèdent en effet, une réflectivité acceptable, voisine de 60 %, ils ne sont pas sensibles au ternissement et présentent une bonne résistance aux agressions mécaniques, du fait de leur dureté élevée. Cette technique présente toutefois des inconvénients majeurs liés à la difficulté de réaliser des revêtements avec ces métaux et à leur coût qui est très élevé.

Certains constructeurs réalisent des miroirs par dépôt d'aluminium pur ou d'argent sur substrat métallique, polymérique ou céramique, protégés par un polymère transparent. De tels miroirs ont d'excellentes propriétés optiques mais sont inutilisables en atmosphère agressive, ils se dégradent très rapidement par ternissement, cloquage et écaillage des revêtements.

On peut citer également des réalisations utilisant une couche de titane associée ou non à une couche de chrome telles que décrites dans FR 2768096, mais de telles réalisations sont rapidement dégradées en ambiance agressive à tel point que FR 2768096 recommande de déposer les couches sur la face arrière d'un support transparent en indiquant qu'elle "est ainsi particulièrement bien protégée vis-à-vis des influences mécaniques et chimiques".

Les alliages du titane et de l'aluminium sont connus par ailleurs. Ils sont utilisés pour conférer au titane des propriétés mécaniques, il s'agit d'alliages à faible teneur en aluminium et contenant généralement du cuivre.

Un objet de la présente invention est de fournir un alliage métallique possédant simultanément la propriété d'être bon réflecteur et formant des liaisons chimiques très fortes avec les substrats, en particulier les substrats polymères, de sorte que les deux interfaces citées plus haut résistent à la plupart des agressions atmosphériques, qu'elles soient de nature industrielle ou saline.

Un autre objet de l'invention est de fournir alliages métalliques intrinsèquement résistants à la corrosion, donc au ternissement.

Un objet de l'invention est encore de fournir un alliage formant avec les substrats, en particulier les substrats polymères des liaisons chimiques qui ne sont pas altérées par des variations de température dans un large domaine d'utilisation.

Un objet de l'invention est aussi de fournir des revêtements réflecteurs à un coût réduit.

Ces objets, ainsi que d'autres qui apparaîtront à la lecture de la description ci-après, sont satisfaits par la présente invention qui fournit un revêtement réflecteur constitué d'une couche d'alliage métallique recouverte d'un film protecteur transparent, caractérisé en ce que le film protecteur est en matériau polymérique et cet alliage métallique est un alliage métallique à base d'aluminium et de titane dont la teneur en aluminium est comprise entre 80 et 90 atomes pour cent et la teneur en titane est comprise entre 10 et 20 atomes pour cent, cet alliage étant déposé sous vide grâce à quoi il est microcristallin et hors équilibre, résistant de ce fait à l'oxydation et à la corrosion et possédant en même temps une capacité d'adhésion à l'égard des matériaux polymériques.

Au sens de l'invention, l'adjectif "microcristallin" qualifie un cristal ayant une taille inférieure à environ 1 µm. Selon l'invention, un alliage microcristallin est donc constitué de cristaux ayant une taille inférieure à environ 1 µm.

Les performances du revêtement réflecteur de l'invention, en particulier en ce qui concerne sa réflectivité, seront d'autant meilleures que l'alliage sera plus pur. Cependant, on peut tolérer jusqu'à environ 2 atomes pour cent d'impuretés sans affecter les performances de l'alliage de façon notable.

Par conséquent, selon un mode de réalisation préféré de l'invention l'alliage métallique comprend une teneur en impuretés au plus égale à environ 2 atomes pour cent.

Selon une réalisation préférentielle de l'invention, l'alliage métallique a une teneur en aluminium comprise entre 84 et 87 atomes pour cent et une teneur en titane comprise entre 13 et 16 atomes pour cent.

Il a fallu vaincre un important préjugé pour parvenir à la présente invention car il est bien connu dans la technique que normalement, l'adjonction d'éléments d'addition à l'aluminium devrait diminuer fortement sa réflectivité.

Des alliages du titane et de l'aluminium sont connus par ailleurs mais il s'agit d'alliages à faible teneur en aluminium et contenant généralement du cuivre qui sont utilisés pour conférer au titane des propriétés mécaniques.

Des alliages d'aluminium à basse teneur en titane ont été décrits, leur teneur en titane ne dépasse pas 1 atome pour cent de titane, généralement associé à des quantités équivalentes de manganèse et de magnésium. Destinés à la fabrication de corps creux sous pression, de tels alliages échappent totalement au champ d'application et au domaine couvert par l'invention.

On connaît, d'après la publication "Binary Alloy Phase Diagrams" de T.B. Massalski, vol. 1, pages 175-176, des alliages d'aluminium et de titane dont la teneur en aluminium est comprise entre 80 et 90 atomes pour cent et la teneur en titane est comprise entre 10 et 20 atomes pour cent. Ces alliages, qui sont hors du champ de la présente invention, sont dans l'équilibre thermodynamique et ils ne sont pas microcristallins. Ils ne possèdent pas la résistance requise à l'oxydation et à la corrosion et ils n'ont pas non plus une capacité d'adhésion remarquable à l'égard des matériaux polymères.

Selon un mode de réalisation préféré de l'invention, le revêtement réflecteur constitué d'une couche d'alliage métallique recouvert d'un film protecteur transparent, caractérisé en ce que ledit alliage métallique est un alliage à base d'aluminium et de titane dont la teneur en aluminium est comprise entre 80 et 90 atomes pour cent et la teneur en titane est comprise entre 10 et 20 atomes pour cent, comprend une teneur en impuretés au plus égale à environ 2 atomes pour cent.

L'épaisseur de la couche d'alliage métallique est en général comprise entre 0,01 et 5 µm.

En deçà de 0,01 µm le revêtement est quasi transparent. Au delà de 5 µm, la réflectivité se dégrade, bien que les autres propriétés ne soient pas affectées.

De préférence, l'épaisseur de la couche d'alliage métallique est comprise entre 0,01 et 3 µm, mieux encore elle est comprise entre 0,01 et 0,5 µm.

La présente invention fournit encore un miroir comprenant un substrat supportant un revêtement réflecteur, caractérisé en ce que ledit revêtement réflecteur est tel que décrit ci-dessus.

Le substrat est en en général un matériau polymérique.

Pour obtenir un miroir spécial ayant une réflectivité spéculaire au moins égale à environ 65 %, une bonne résistance à la corrosion et à l'oxydation, il faudra choisir un revêtement réflecteur constitué d'une couche d'alliage métallique recouvert d'un film protecteur transparent, caractérisé en ce que ledit alliage métallique est un alliage à base d'aluminium et de titane microcristallin et hors équilibre thermodynamique dont la teneur en aluminium est comprise entre 80 et 90 atomes pour cent et la teneur en titane est comprise entre 10 et 20 atomes pour cent comprenant une teneur en impuretés au plus égale à environ 2 atomes pour cent avec une l'épaisseur de la couche d'alliage comprise entre 0,01 et 3 µm.

Lorsque les revêtements réflecteurs de l'invention sont déposés sur un substrat polymérique et eux-mêmes protégés par un film protecteur transparent, l'ensemble peut être exposé à une atmosphère corrosive comme celle du test dit de brouillard salin selon la norme ISO 9227 sans affectation de la réflectivité ni apparition de défauts aux interfaces.

Les techniques de dépôt sous vide de l'alliage aluminium/titane telles que la pulvérisation cathodique magnétron, l'évaporation et la coévaporation sous certaines conditions (pouvant aisément être déterminées par l'homme du métier pour obtenir des microcristaux), représentent des moyens particulièrement indiqués pour réaliser de tels matériaux sous forme de couches minces.

Les miroirs de l'invention, en particulier les miroirs spéciaux, peuvent faire partie de pièces telles que des rétroviseurs pour automobiles ou bien des enseignes publicitaires.

L'affinité et l'adhérence de l'alliage de l'invention vis à vis des polymères est très importante.

La résistance à la corrosion est également importante car la face réfléchissante du miroir est en contact direct avec les agents atmosphériques et n'est pas protégée de l'oxydation.

Le brevet Nippon Jidosha JP 61133902 décrit un miroir constitué d'un substrat en verre sur lequel sont déposés successivement une couche transparente de TiO₂ et une couche réflectrice d'un alliage d'aluminium, par exemple de titane. Il s'agit de faire un miroir coloré, la couleur ayant été obtenue grâce à un phénomène d'interférences lumineuses dans la couche de TiO₂. Le dioxyde de titane est le composant le plus important de ce miroir coloré. Il faut noter que la couche réfléchissante d'alliage d'aluminium est située sur la partie arrière du verre par rapport aux rayons lumineux; sa face réfléchissante est donc protégée de l'oxydation. De plus, l'alliage d'aluminium de ce brevet, qui est en contact avec une céramique, n'a pas, contrairement à celui de la présente invention, à être adhérent ou à avoir d'affinité vis à vis d'un polymère, les céramiques étant tout à fait différentes des polymères sur le plan physico-chimique.

L'invention sera à présent décrite plus en détails en référence aux exemples non limitatifs suivants.

### Exemple 1.

Cet Exemple concerne la réalisation d'un miroir destiné à fonctionner en ambiance extérieure.

La structure de ce miroir est réalisée en polycarbonate (substrat).

Il doit résister à l'usure abrasive par des particules entraînées par le vent et également à la corrosion due à la pluie et aux atmosphères industrielles. Pour cela, on dépose par dépôt sous vide, pulvérisation cathodique magnétron, une couche d'épaisseur 0,1 µm d'alliage aluminium titane conforme à l'invention, contenant 85 atomes pour cent d'aluminium, le reste étant du titane, que l'on protège ensuite par un enduit transparent (film protecteur) et résistant à l'abrasion à base de polysiloxane.

La réflectivité de ce miroir est de 67 % ± 1 %, l'adhérence des revêtements est mesurée, conformément à la norme ISO 2409 et le résultat est classé 0. Le miroir est vieilli artificiellement par exposition à une atmosphère saline conformément à la norme ISO 9227 pendant 400 heures. Il est ensuite lavé, séché et soumis à nouveau au test d'adhérence; le résultat est classé 0, aucun décollement ou écaillage n'étant apparu. La réflectivité après le test est de 66 % ± 1 %, la différence par rapport à la valeur initiale est de l'ordre de grandeur des erreurs de mesure.

A titre de comparaison, on a soumis aux mêmes sollicitations un miroir classiquement réalisé par dépôt d'aluminium pur de même épaisseur, sur un substrat en polycarbonate, puis recouvrement par le même enduit polysiloxane ; après 400 heures d'exposition au brouillard salin, les revêtements sont décollés sur 30 % environ de la surface du miroir qui est alors inutilisable.

### Exemple 2

On réalise un miroir pour chauffage à infrarouge. Ce miroir doit pouvoir supporter des températures de service de 200°C sans affectation de ses performances. Pour cela, on utilise une structure en polyéthérimide, que l'on revêt par dépôt sous vide d'une couche d'alliage aluminium titane, conforme à l'invention. Sa composition est de 87 atomes pour cent d'aluminium et de 13 atomes pour cent de titane, son épaisseur de 5 micromètres.

La réflectivité intrinsèque de ce miroir est de 70 %. L'adhérence du revêtement, contrôlée selon la méthode citée dans l'exemple 1, donne un résultat classé 0. On fait subir au miroir une série de tests alternant des maintiens de 1 heure à 200°C et des maintiens de 2 heures à température ambiante. L'essai est arrêté après 10 cycles et les caractéristiques sont mesurées à nouveau. Le test d'adhérence conduit à la qualification 0, la réflectivité est inchangée.

A titre de comparaison, on a fait subir les mêmes tests à deux miroirs correspondant à l'état de l'art, l'un d'eux est obtenu par un revêtement de 1 micromètre d'or sur substrat polyéthérimide, l'autre par un revêtement d'aluminium pur sur même substrat. Après la série de 10 cycles, le revêtement d'or est partiellement décollé, rendant le miroir inutilisable, le revêtement d'aluminium dont la réflectivité était de 95 %, voit cette dernière passer à 52 % par croissance d'une couche d'oxyde superficielle.

### Exemple 3

On réalise une enseigne publicitaire destinée à être exposée à l'extérieur. Cette enseigne réalisée en acrylonitrile-butadiene-styrène (ABS) doit présenter un aspect métallique brillant. La durée de vie sur site doit être supérieure à 5 ans.

Pour cela, on métallise une enseigne avec un alliage d'aluminium et de titane conforme à l'invention dont la composition est de 82 atomes pour cent d'aluminium et de 18 atomes pour cent de titane. Son épaisseur est de 0,3 micromètres. Ce dernier est ensuite revêtu d'un vernis protecteur transparent d'épaisseur 20 micromètres. L'adhérence des revêtements évaluée conformément au test cité dans l'Exemple 1, est mesurée à 0, sa réflectivité est de 68 %.

Le vieillissement est simulé par une exposition de 100 heures au brouillard salin selon le test normalisé décrit à l'Exemple 1. A l'issue du test, l'enseigne est lavée, séchée et ses caractéristiques sont mesurées à nouveau. L'adhérence reste inchangée et la réflectivité est de 65 %, cette faible variation est liée à une légère attaque superficielle du vernis protecteur par la vapeur saline.

A titre de comparaison, on a fait subir les mêmes tests à une enseigne revêtue d'un dépôt de chrome d'épaisseur 0,1 micromètre, réalisé par technique galvanique classique et protégé par le même vernis. La réflectivité est de 70 % et l'adhérence est classée 0. Après exposition au brouillage salin, la réflectivité est passée à 66 % pour les mêmes raisons, mais l'adhérence n'est plus que de niveau 1.

### Exemple 4 ; Alliage non microcristallin (non conforme à l'invention)

Pour réaliser des miroirs à haute performance sur un substrat léger en matière plastique, on coule un lingot d'alliage AlTi contenant 13 % de titane que l'on lamine pour obtenir une feuille d'épaisseur 10 µm. Un examen de cette feuille aux rayons X confirme sa structure cristallographique est conforme à celle prévue par le diagramme d'état aluminium titane.

Cet alliage n'est pas microcristallin et est dans l'équilibre thermodynamique.

Cette feuille d'alliage est ensuite colaminée sur un film polymère de façon à réduire l'épaisseur de la couche métallique à 0,2 µm.

Ce film plastique métallisé est ensuite collé sur le substrat en polycarbonate constituant l'ossature du miroir. L'ensemble est alors recouvert d'une couche de vernis antirayure transparent pour protéger la surface réfléchissante des agressions, cette technique permettant une industrialisation aisée et une fabrication en série à bas coût.

La réflectivité d'un tel miroir est de 75 %.

Afin de vérifier sa tenue dans le temps, on a soumis ce miroir au test de brouillard salin tel que décrit dans l'Exemple 1 ci-dessus. Après 24 heures d'essai, ce qui est notablement insuffisant, la couche de vernis protecteur est particulièrement dégradée. Un examen au microscope montre que l'origine de cette dégradation provient d'une adhérence insuffisante du vernis polymère sur l'alliage aluminium titane ainsi réalisé.

## Revendications

1. Revêtement réflecteur constitué d'une couche d'alliage métallique recouverte d'un film protecteur transparent, **caractérisé en ce que** le film protecteur est en matériau polymérique et cet alliage métallique est un alliage métallique à base d'aluminium et de titane dont la teneur en aluminium est comprise entre 80 et 90 atomes pour cent et la teneur en titane est comprise entre 10 et 20 atomes pour cent, cet alliage étant déposé sous vide grâce à quoi il est microcristallin et hors équilibre, résistant de ce fait à l'oxydation et à la corrosion et possédant en même temps une capacité d'adhésion à l'égard des matériaux polymériques.

2. Revêtement réflecteur selon la revendication 1, **caractérisé en ce que** l'alliage comprend une teneur en impuretés au plus égale à environ 2 atomes pour cent.

3. Revêtement réflecteur selon la revendication 1 ou la revendication 2, **caractérisé en ce que** la teneur en aluminium de l'alliage est comprise entre 84 et 87 atomes pour cent et **en ce que** sa teneur en titane est comprise entre 13 et 16 atomes pour cent.

4. Revêtement réflecteur selon l'une quelconque des revendications 1 à 3, **caractérisé en ce que** l'épaisseur de la couche d'alliage métallique est comprise entre 0,01 et 5 µm.

5. Revêtement réflecteur la revendication 4, **caractérisé en ce que** l'épaisseur de la couche d'alliage métallique est comprise entre 0,01 et 3 µm.

6. Revêtement réflecteur selon la revendication 5, **caractérisé en ce que** l'épaisseur de la couche d'alliage métallique est comprise entre 0,01 et 0,5 µm.

7. Miroir comprenant un substrat supportant un revêtement réflecteur, **caractérisé en ce que** ledit revêtement réflecteur est un revêtement selon l'une quelconque des revendications 1 à 6.

8. Miroir selon la revendication 7, **caractérisé en ce que** le substrat est un matériau polymérique.

9. Miroir ayant une réflectivité spéculaire au moins égale à environ 65 %, une bonne résistance à la corrosion et à l'oxydation, comprenant un substrat supportant un revêtement réflecteur, **caractérisé en ce que** ledit revêtement réflecteur est un revêtement selon l'une quelconque des revendications 1 à 6.

10. Pièce comportant un miroir, **caractérisée en ce que** ledit miroir est un miroir spécial selon la revendication 9.

11. Pièce selon la revendication 10, **caractérisée en ce qu'**elle est constituée d'un rétroviseur pour automobiles.

12. Pièce selon la revendication 10, **caractérisée en ce qu'**elle est constituée d'une enseigne publicitaire.

## Patentansprüche

1. Reflektionsbeschichtung, bestehend aus einer mit einem transparenten Schutzfilm beschichteten Schicht einer Metallegierung, **dadurch gekennzeichnet, daß** der Schutzfilm ein Polymermaterial und die Metallegierung eine Metallegierung auf Basis von Aluminium und Titan mit einem Aluminiumgehalt von 80 bis 90 Atom-% und einem Titangehalt von 10 bis 20 Atom-% ist, wobei die Legierung unter Vakuum aufgebracht ist, infolge dessen sie mikrokristallin und außerhalb des Gleichgewichts ist und aufgrund dessen sie beständig gegenüber Oxidation und Korrosion ist und gleichzeitig ein Adhäsionsvermögen in bezug auf Polymermaterialien aufweist.

2. Reflektionsbeschichtung nach Anspruch 1, **dadurch gekennzeichnet, daß** die Legierung einen Gehalt an Verunreinigungen von höchstens etwa 2 Atom-% aufweist.

3. Reflektionsbeschichtung nach Anspruch 1 oder 2, **dadurch gekennzeichnet, daß** der Aluminiumgehalt der Legierung 84 bis 87 Atom-% beträgt und daß ihr Titangehalt 13 bis 16 Atom-% beträgt.

4. Reflektionsbeschichtung nach einem der Ansprüche 1 bis 3, **dadurch gekennzeichnet, daß** die Schichtdicke der Metallegierung 0,01 bis 5 µm beträgt.

5. Reflektionsbeschichtung nach Anspruch 4, **dadurch gekennzeichnet, daß** die Schichtdicke der Metallegierung 0,01 bis 3 µm beträgt.

6. Reflektionsbeschichtung nach Anspruch 5, **dadurch gekennzeichnet, daß** die Schichtdicke der Metallegierung 0,01 bis 0,5 µm beträgt.

7. Spiegel, aufweisend einen Träger mit einer Reflektionsbeschichtung, **dadurch gekennzeichnet, daß** die Reflektionsbeschichtung eine Beschichtung nach einem der Ansprüche 1 bis 6 ist.

8. Spiegel nach Anspruch 7, **dadurch gekennzeichnet, daß** der Träger ein Polymermaterial ist.

9. Spiegel mit einer Spiegelreflektion (Spekularreflektion) von mindestens etwa 65 % und einer guten Beständigkeit gegenüber Korrosion und Oxidation, aufweisend einen Träger mit einer Reflektionsbeschichtung, **dadurch gekennzeichnet, daß** die Reflektionsbeschichtung eine Beschichtung nach einem der Ansprüche 1 bis 6 ist.

10. Bauteil mit einem Spiegel, **dadurch gekennzeichnet, daß** der Spiegel ein Spezialspiegel nach Anspruch 9 ist.

11. Bauteil nach Anspruch 10, **dadurch gekennzeichnet, daß** es ein Rück- bzw. Seitenspiegel fiir Kraftfahrzeuge ist.

12. Bauteil nach Anspruch 10, **dadurch gekennzeichnet, daß** es ein Reklameschild ist.

## Claims

1. A reflective coating consisting of a layer of metal alloy covered with a transparent protective film, **characterized in that** the protective film is made of polymer material and this metal alloy is a metal alloy based on aluminum and titanium whose aluminum content is from 80 to 90 atoms percent, whose titanium content is from 10 to 20 atoms percent, this alloy being deposited under vacuum by virtue of which it is microcrystalline and not in equilibrium, therefore resistant to oxidation and to corrosion, and simultaneously having a capacity for adhesion to polymer materials.

2. A reflective coating according to claim 1, **characterized in that** the alloy has an impurities content at most equal to approximately 2 atoms percent.

3. A reflective coating according to either claim 1 or claim 2, **characterized in that** the aluminum content of the alloy is from 84 to 87 atoms percent and **in that** its titanium content is from 13 to 16 atoms percent.

4. A reflective coating according to any of claims 1 to 3, **characterized in that** the metal alloy layer is from 0.01 to 5 µm thick.

5. A reflective coating according to claim 4, **characterized in that** the metal alloy layer is from 0.01 to 3 µm thick.

6. A reflective coating according to claim 5, **characterized in that** the metal alloy layer is from 0.01 to 0.5 µm thick.

7. A mirror comprising a substrate supporting a reflective coating, **characterized in that** said reflective coating is a coating according to any of claims 1 to 6.

8. A mirror according to claim 7, **characterized in that** the substrate is a polymer material.

9. A mirror having a specular reflectivity at least equal to approximately 65% and good resistance to corrosion and to oxidation, the mirror comprising a substrate supporting a reflective coating, **characterized in that** said reflective coating is a coating according to any of claims 1 to 6.

10. A component including a mirror, **characterized in that** said mirror is a special mirror according to claim 9.

11. A component according to claim 10, **characterized in that** it constitutes an automobile rear view mirror.

12. A component according to claim 10, **characterized in that** it constitutes a billboard.
